## Europäisches Patentamt

## European Patent Office

## Office européen des brevets

(19)

(11) Veröffentlichungsnummer: **0 046 574**
**B1**

(12)

# EUROPÄISCHE PATENTSCHRIFT

(45) Veröffentlichungstag der Patentschrift:
**19.11.87**

(51) Int. Cl.⁴: **H 03 M 1/46**

(21) Anmeldenummer: **81106487.2**

(22) Anmeldetag: **20.08.81**

(54) Verfahren zum Nullpunktabgleich des durch einen Operationsverstärker realisierten Analogwertvergleichers eines unter Verwendung eines Digital-Analog-Wandlers nach dem Iterativprinzip arbeitenden Analog-Digital-Wandlers, insbesondere bei dessen Zugehörigkeit zu einer Einrichtung zur Analog-Digital-Wandlung und umgekehrt zur Digital-Analog-Wandlung (Codec).

(30) Priorität: **21.08.80 DE 3031592**

(43) Veröffentlichungstag der Anmeldung:
**03.03.82 Patentblatt 82/9**

(45) Bekanntmachung des Hinweises auf die Patenterteilung:
**19.11.87 Patentblatt 87/47**

(84) Benannte Vertragsstaaten:
**AT BE CH FR GB IT LI NL SE**

(56) Entgegenhaltungen:
**DE - A - 2 534 109**
**DE - A - 2 649 117**

**INSTRUMENTS AND EXPERIMENTAL TECHNIQUES, Band 23, Nr. 4, Teil 1, Juli/August 1980, Seiten 928-930, New York, USA A.V. ZHUKOV et al.: "Comparator with automatic offset correction"**
**IEEE JOURNAL OF SOLID STATE CIRCUITS, Band SC-13, Nr. Juni 1978, Seiten 285-294, New York, USA D.A. HODGES et al.: "Potential of MOS technologies for analog integrated circuits"**

(73) Patentinhaber: **Siemens Aktiengesellschaft Berlin und München, Wittelsbacherplatz 2, D-8000 München 2 (DE)**

(72) Erfinder: **Lechner, Robert, Dipl.-Ing., Haidfeldstrasse 5, D-8156 Otterfing (DE)**
Erfinder: **von Sichart, Frithjof, Dr. Dipl.-Phys., Karl-Theodor-Strasse 72, D-8000 München 40 (DE)**
Erfinder: **Picard, Peter, Dipl.-Ing., Platanenstrasse 172, D-8021 Taufkirchen (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft ein Verfahren zum Nullpunktabgleich des durch einen Operationsverstärker realisierten Analogwertvergleichers eines nach dem Iterativprinzip arbeitenden Analog-Digitalwandlers, entsprechend dem Oberbegriff des Patentanspruchs 1.

Die Verwendung eines Operationsverstärkers zur Realisierung des Analogwertvergleichers bedingt einen sogenannten Offset-Fehler, d.h. auch dann wenn die Spannungsdifferenz zwischen den Eingängen des Vergleichers 0 ist, wird eine Ausgangsspannung abgegeben, die von 0 abweicht und damit fälschlicherweise das Vorliegen einer Ungleichheit der den beiden Eingängen zugeführten Signale anzeigt. Im Bereich des Nullpunkts der der Analog-Digital-Wandlung zugrundeliegenden Kennlinie hat ein solcher Offset-Fehler zur Folge, dass sehr kleine Eingangssignale, die durch Nebensprechen bedingt sind und die wegen der Quantisierung bei einer solchen Codewandlung unterdrückt werden könnten, dennoch als Nutzsignal bewertet werden, das die erste Quantisierungsstufe überschritten hat. Das bedeutet also, dass in diesem Falle bei fehlendem Nullpunktabgleich die Nebensprechforderungen nicht mehr eingehalten werden.

Es ist zwar möglich, den genannten Nullpunktfehler dadurch abzugleichen, dass mit Hilfe von Potentiometern an den Eingängen des Vergleichers die sogenannte Offset-Spannung eingestellt wird, die so gross ist, dass das Ausgangssignal gerade 0, der Offset-Fehler also kompensiert ist. Diese Art der Kompensation ist wegen der erforderlichen Abgleicharbeit teuer und gewährleistet darüber hinaus nicht, dass alterungsbedingte Langzeiteffekte Berücksichtigung finden.

Eine andere bekannte Massnahme zum Nullabgleich des Vergleichers bei Analog-Digital-Wandlern besteht darin, mit einer Regelschaltung im Ruhezustand wenn kein umzuwandelndes Analogsignal vorliegt, mit gleicher Wahrscheinlichkeit positives und negatives Vorzeichen des sich aus dem dann vorliegenden Null-Wert ergebenden Digital-Signals zu erzwingen, wozu wechselweise Spannungen entgegengesetzter Polarität abgebende Spannungsquellen wirksam geschaltet werden. Da bei den Sprachsignalen, um die es sich bei den zu codierenden Analogwerten handelt, das Auftreten von negativen und positiven Vorzeichen nicht gleichmässig verteilt ist, ergibt sich ausserhalb der Gesprächspausen eine Verschiebung des Nullpunktes, die in darauffolgenden Sprechpausen durch den genannten Regelkreises wieder rückgängig gemacht wird, wozu alle diejenigen Quantisierungsintervalle in entgegengesetzter Richtung durchlaufen werden, um die die Verschiebung stattgefunden hat. Dieser Vorgang ist wiederum die Ursache von störenden Geräuschen. Ausserdem erfordert das genannte bekannte Verfahren ein sehr genaues Übereinstimmen der Spannungswerte, die zum Entstehen der beiden erzwungen gleich wahrscheinlich auftretenden Vorzeichen führen, was einen hohen technologischen Aufwand bedingt.

Aufgabe der vorliegenden Erfindung ist es daher, ein Verfahren anzugeben, das einen Nullpunktabgleich gewährleistet, der sich kostengünstig realisieren lässt, auch Langzeiteffekte berücksichtigt und die vorgenannten Störungen vermeidet.

Erfindungsgemäss wird diese Aufgabe durch die im kennzeichnenden Teil des Patentanspruchs 1 angegebenen Verfahrensschritte gelöst.

Die Verwendung eines Nullabgleichkondensators, der einem Analogwertvergleicher eines Analog-Digital-Umsetzers zugeordnet ist, ist für sich bekannt (DE-OS 2 649 117). Im bekannten Fall geht es allerdings nicht darum, den Offset-Fehler des Komparators zu kompensieren sondern den Offset-Fehler einer Messverstärkerkette die das zu wandelnde Analogsignal an den Vergleicher liefert. Die Verfahrensschritte, die im bekannten Falle abgewickelt werden, könnten daher die erfindungsgemässe Aufgabe nicht lösen.

Gemäss einer weiteren Ausgestaltung der Erfindung wird angegeben, wie ausser dem Nullpunktabgleich des Vergleichers auch ein Nullpunktabgleich eines ebenfalls in Form eines Operationsverstärkers realisierten Strom-Spannungswandlers, über den das Ausgangssignal des genannten zum Analog-Digital-Wandler gehörenden Digital-Analog-Wandlers vorgenommen wird, sofern dieser ein Stromvergleicher ist oder wie ausserdem ein Nullpunktabgleich des Spannungs-Stromwandlers vorgenommen werden kann, über den das umzuwandelnde Analog-Signal dem Vergleicher zugeführt wird, sofern dieser ein Spannungsvergleicher ist. Nullpunktfehler dieser Strom-Spannungswandler bzw. Spannungs-Stromwandler haben nämlich einen Linearitätsfehler bei der Codewandlung zur Folge. Bisher wurde ein solcher Nullpunktabgleich ebenfalls mit Hilfe von Potentiometern vorgenommen, was die vorgenannten Nachteile hat.

Durch noch eine andere Ausgestaltung der Erfindung werden die Verhältnisse berücksichtigt, die sich dann ergeben wenn der Schalter, über den die umzuwandelnden Analogspannungswerte einem Abtastkondensator zugeführt werden und der zum Überbrücken dieses Abtastkondensators während des Nullabgleichs dienende Schalter in Form von MOS-Transistoren realisiert sind. Diese Verhältnisse führen nämlich, sofern keine Gegenmassnahmen getroffen werden, ebenfalls zu einer Nullpunktverfälschung.

Nachstehend wird das erfindungsgemässe Verfahren anhand von Ausführungsbeispielen unter Bezugnahme auf fünf Figuren näher erläutert. Von den Figuren zeigen:

Figur 1 eine Schaltungsanordnung zur Durchführung des Nullpunktabgleiches unter Verwendung eines Nullabgleichkondensators.

Die Figur 2 ein Ausführungsbeispiel eines Rückkoppelnetzwerkes.

Die Figuren 3 bis 4 Beispiele für das erfindungsgemäss vorgesehene Rückkoppelnetzwerk.

Figur 5 eine Schaltungsanordnung zur Durchführung einer zweiten Variante des erfindungsgemässen Verfahrens.

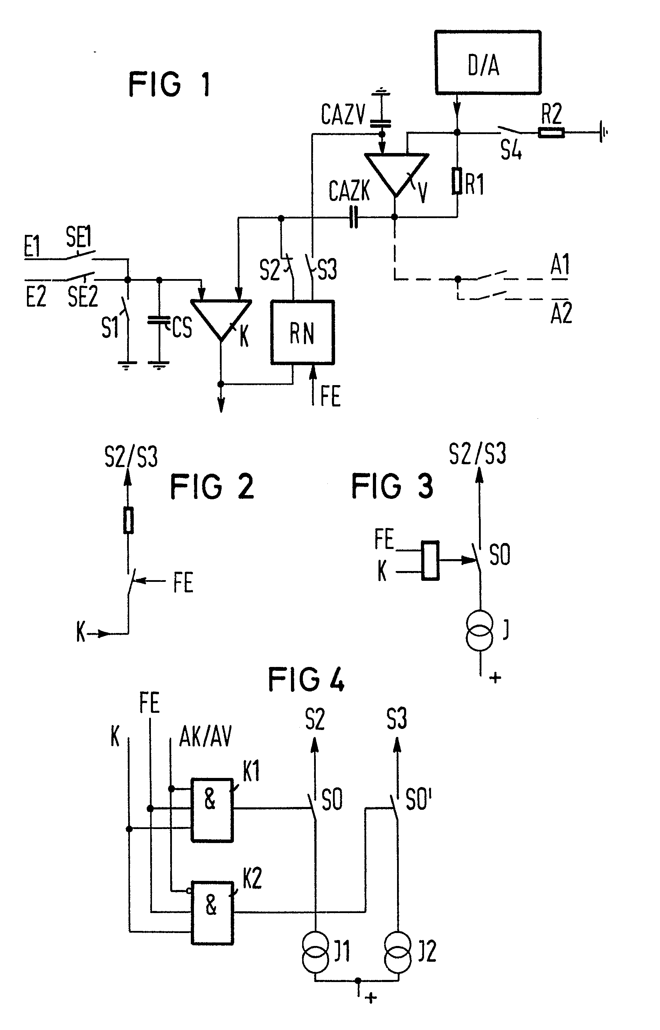

Die Figur 1 zeigt in zur Erläuterung des erfindungsgemässen Verfahrens erforderlichem Umfang eine Anordnung zur Analog-Digital-Wandlung und umgekehrt zur Digital-Analog-Wandlung (Codec), die zwei nicht dargestellten Fernsprechteilnehmerstationen zugeordnet ist (Zwei-Kanal-Codec). Die von den Fernsprechstationen gelieferten Analogsignale gelangen über nicht dargestellte Filter und über Abtastschalter SE1 und SE2, die jeweils während eines anderen Teils des Umwandlungszyklus geschlossen sind, an einen Haltekondensator CS, der aus noch zu erläuternden Gründen von einem Schalter S1 überbrückt werden kann. Die eine Belegung des Haltekondensators CS ist mit einem Eingang eines Vergleichers K verbunden, dessen anderem Eingang ein Analogsignal zugeführt wird, das sich aus der durch den Digital-/Analog-Wandler D/A bewirkten Digital-Analog-Wandlung eines Digitalwertes ergibt, der durch entsprechende Einstellung der Stufen eines nicht dargestellten Zwischenregisters dargestellt worden ist. Wenn am Ausgang des Vergleichers K ein Ungleichheit anzeigendes Signal auftritt, wird in dem erwähnten Zwischenregister ein anderer Digitalwert eingestellt, woraufhin sich die beschriebenen Vorgänge wiederholen. Auf diese Art und Weise erfolgt eine iterative Annäherung des eingestellten Digitalwerts an den im Haltekondensator CS gespeicherten Analogwert, wie es für sich, z.B. aus der DE-OS 2 534 109 bekannt ist. Bei der Umwandlung von für die Teilnehmerstationen bestimmten Digitalwerten in Analogwerte ist lediglich der Digital-Analog-Wandler D/A wirksam, in welchem Falle die von ihm abgegebenen Ausgangssignale über einen der Schalter A1 und A2 an die betreffenden Teilnehmerstationen weitergeleitet werden.

Der Digital-Analog-Wandler D/A ist in Form eines R-2R-Widerstandsnetzwerkes realisiert und liefert an seinem Ausgang I Summenströme, die den an seinem Eingang anliegenden Digitalwerten entsprechend und im Zuge einer Analog-Digital-Wandlung über einen Strom-Spannungswandler V und einen Koppelkondensator CAZK, der beim erfindungsgemässen Verfahren eine ausschlaggebende Rolle spielt, an den anderen Eingang des Vergleichers K gelangen.

Der Ausgang des Vergleichers K ist über ein Rückkopplungsnetzwerk RN und einen Schalter S2 mit dem erwähnten, mit dem Kondensator CAZK verbundenen Eingang verbindbar (wobei FE ein Steuersignal ist). Das Rückkopplungsnetzwerk kann über den Schalter S3 ausserdem an den nicht mit dem Digital-Analog-Wandler D/A verbundenen Eingang des Strom-Spannungswandlers V verbunden werden, an dem ausserdem ein Kondensator CAZV angeschlossen ist. Der andere Eingang dieses Strom-Spannungswandlers ist über den Widerstand R1 mit dem Wandlerausgang verbunden und kann über den Schalter S4 und den Widerstand R2, dessen Widerstandswert klein gegenüber demjenigen des Widerstands R1 ist, an Bezugspotential gelegt werden.

In Durchführung des Verfahrens wird zu Beginn der Abgleichphase das Ausgangssignal des Digital-Analog-Wandlers D/A in nicht näher dargestellter Weise und die an dem mit dem Haltekondensator CS verbundenen Eingang liegende Spannung durch Schliessen des Schalters S1 zu Null gemacht. Daraufhin wird durch Schliessen des Schalters S2 das Rückkopplungsnetzwerk RN mit dem anderen Eingang des Vergleichers K in Verbindung gebracht. Über dieses Rückkopplungsnetzwerk erfolgt daher eine Aufladung des Kondensators CAZK, wobei diese Aufladung soweit gehen soll, dass ein Ladungszustand entsteht, bei dem das Ausgangssignal des Vergleichers an die Entscheidungsschwelle zwischen den Gleichheit bzw. Ungleichheit der an den Vergleichereingängen anliegenden Analogwerte, die hier voraussetzungsgemäss Null sind, anzeigenden Ausgangssignalzuständen gelangt. Damit ist erreicht, dass beim nachfolgenden Betrieb des Analog-Digital-Wandlers im nullpunktnahen Bereich nur solche im Haltekondensator CS gespeicherte Analogwerte zur Erzeugung eines von Null abweichenden Digitalwertes führen, deren Amplitude grösser als die erste Quantisierungsstufe ist.

Wie die Figur 2 zeigt, kann das Rückkopplungsnetzwerk RN im einfachsten Fall ein hochohmiger Widerstand R sein, über den der Kondensator CAZK solange aufgeladen wird, bis am Ausgang des Vergleichers K ein Potentialwechsel auftritt, woraufhin der Kondensator sich wieder entlädt, bis es zu einem entgegengesetzten Potentialwechsel am Vergleicherausgang kommt usw. usw.

Häufig liegt der Fall vor, dass der Vergleicher in bipolarer Halbleitertechnologie realisiert ist, was bedeutet, dass das eingangsseitige Verstärkerelement dauernd einen Eingangsstrom erfordert, der zu einem kontinuierlichen Entladen des Kondensators CAZK führt. In diesem Fall ist das Rückkopplungsnetzwerk RN entsprechend Figur 3 ausgebildet, enthält also eine Konstantstromquelle I, wobei der Schalter S0, über den diese Konstantstromquelle wirksam geschaltet wird, in der Nullabgleichphase nur dann geschlossen wird, wenn die erwähnte Entladung des Kondensators CAZK ausgeglichen werden muss. Der Strom hat hierbei eine solche Amplitude, dass sie über die Abtastperiode, die auch die Umwandlungsperiode bestimmt, gemittelt den Mittelwert des genannten Entladungsstroms übersteigt, so dass der Kompensationszustand diese Periode überdauert.

Gemäss der Erfindung wird ausser dem Nullpunktabgleich des Vergleichers K auch ein Nullpunktabgleich des gegebenenfalls vorhandenen Strom-Spannungswandlers bzw. Spannungs-Stromwandlers vorgenommen. Da in Figur 1 ein Spannungsvergleicher K vorausgesetzt worden ist, handelt es sich bei dem Wandler dort um einen Strom-Spannungswandler, der den vom Digital-Analog-Wandler abgegebenen Summenstrom in einen Spannungswert umwandelt. Der Nullpunktabgleich des Strom-Spannungswandlers V schliesst sich direkt an denjenigen des Vergleichers K an, wozu, nachdem der Schalter S2 geöffnet worden ist, die Schalter S3 und S4 geschlossen werden. Durch das Schliessen des Schalters S4 wird der mit dem Ausgang des Digital-Analog-Wandlers D/A verbundene Eingang des Strom-Spannungs-Wandlers V über den Widerstand R2 an Erde gelegt mit der Folge, dass die an diesem Eingang liegende Offset-Spannung im Verhältnis R1/R2 verstärkt wird. Das Ausgangssignal des Strom-Spannungs-Wandlers V gelangt dann an den einen Eingang des Vergleichers K, der in der beschriebenen Art und Weise bereits abgeglichen wurde. Das Ausgangssignal des Vergleichers gelangt über das Rückkopplungsnetzwerk und den Schalter S3 auf den Kondensator CAZV und bewirkt eine Aufladung desselben in der im Zusammenhang mit dem Kondensator CAZK beschriebenen Art und Weise. Da durch die vorerwähnte Betätigung des Schalters S4 der Offset-Fehler des Wandlers V vor dem Abgleich verstärkt worden ist, hat ein gegebenenfalls beim Vergleicher vorher noch nicht völlig abgeglichener Nullpunktfehler keinen Einfluss auf das Gesamtabgleichergebnis mehr.

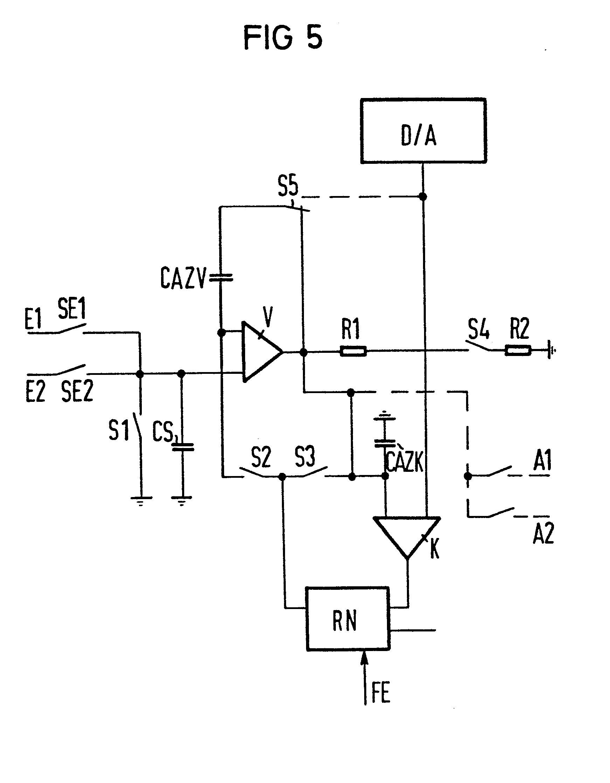

Bei der Schaltungsanordnung gemäss Figur 5 ist der Vergleicher K ein Stromvergleicher. Seinem einen Eingang wird daher der von der Einrichtung zur Digital-Analog-Wandlung D/A gelieferte Summenstrom und seinem anderen Eingang der umzuwandelnde Analogwert in Form eines Stromwertes zugeführt, der durch einen Spannungs-Strom-Wandler V aus der Ladespannung des Haltekondensators CS erzeugt worden ist. An dem letztgenannten Eingang des Vergleichers K ist ein Nullabgleichkondensator CAZK angeschlossen, der nicht mit dem Haltekondensator verbundene andere Eingang des Spannungs-Stromwandlers V liegt an einem Nullabgleichkondensator CAZV.

Beim Abgleich spielen sich entsprechende Vorgänge ab, wie bei der Schaltungsanordnung gemäss Figur 1. Das heisst, dass durch Schliessen des den Haltekondensator CS überbrückenden Schalters S1 und durch eine entsprechende Schaltmassnahme innerhalb der Einrichtung D/A die Eingangsgrössen für den Vergleicher K zu Null gemacht werden und durch Schliessen des Schalters S3 das Rückkopplungsnetzwerk RN, das wie vorstehend beschrieben, entsprechend den Figuren 2 bis 4 ausgebildet sein kann, in den Rückkopplungskreis zwischen dem Ausgang des Vergleichers K und demjenigen Eingang gelegt wird, an dem der Nullabgleichkondensator (CAZK) liegt, und dass dieser Kondensator in der beschriebenen Weise aufgeladen wird. Nach Öffnen des Schalters S3 wird durch Schliessen des Schalters S2 das Rückkopplungsnetzwerk zwischen den Ausgang des Vergleichers K und denjenigen Eingang des Spannungs-Stromwandlers V gelegt, an dem der andere Nullabgleichkondensator CAZV angeschlossen ist, ferner wird der Schalter S4 geschlossen. Die Vorgänge, die sich bei der Aufladung des letztgenannten Nullabgleichkondensators abspielen, sind dieselben, wie vorstehend im Zusammenhang mit Figur 1 erläutert. Die gestrichelt dargestellten Teile der Figur 5 sind nur bei einer Digital-Analog-Wandlung wirksam, bei der jedoch keine Abgleichmassnahmen erforderlich sind.

Wenn die Gegebenheiten vorliegen, die, wie erläutert, zum Einsatz eines Rückkopplungsnetzwerkes gemäss Figur 3 führen, kann alternativ auch ein Rückkopplungsnetzwerk gemäss Figur 4 eingesetzt werden, das zwei Stromquellen I1 und I2 aufweist, die aufgrund von durch die Koinzidenzglieder K1 und K2 gelieferte Ansteuersignale über die Schalter S0 und S0', je nachdem ob der Vergleicher K oder der Wandler V abgeglichen werden soll (Signal AK oder AV), alternativ wirksam geschaltet werden. Diese Ausbildung des Rückkopplungsnetzwerkes hat Vorteile bezüglich einer Realisierung in integrierter Schaltkreistechnik.

In der Praxis sind die Schalter SE1, SE2 und S1 der Anordnungen gemäss den Figuren 1 und 5 häufig als MOS-Transistoren realisiert. Wegen der parasitären Gate-Drain-Kapazität kommt es bei negativen Spannungssprüngen am Haltekondensator Cs zu einer Spannungsverschiebung, die sich genauso auswirkt wie ein Offset-Fehler des Vergleichers. Gemäss weiterer Ausgestaltung der Erfindung wird dieser Fehler daher in derselben Weise wie ein Offset-Fehler kompensiert, wozu, identische Realisierung der genannten drei Schalter vorausgesetzt, der den Haltekondensator CS überbrückende Schalter S1, wie schon erläutert, unmittelbar vor Beginn der Nullabgleichphase geschlossen wird, dann jedoch, bevor der eigentliche Abgleich einsetzt, wieder geöffnet wird. Der hierdurch bewirkte Fehler wird in derselben Weise wie der eigentliche Offset-Fehler des Vergleichers in der beschriebenen Weise kompensiert, wodurch die durch Öffnen der Schalter SE1 und SE2 bedingten Fehler während des nachfolgenden Analog-Digital-Wandlungsvorganges berücksichtigt werden.

**Patentansprüche**

1. Verfahren zum Nullpunktabgleich des durch einen Operationsverstärker realisierten Analogwertvergleichers eines unter Verwendung eines Digital-Analog-Wandlers nach dem Iterativprinzip arbeitenden Analog-Digital-Wandlers, insbesondere bei dessen Zugehörigkeit zu einer Einrichtung zur Analog-Digital-Wandlung und umgekehrt zur Digital-Analog-Wandlung (Codec), wobei in der Abgleichphase ein Nullabgleichkondensator (CAZK), der an einen ersten Eingang des Vergleichers (K) angeschlossen ist, über ein Rückkopplungsnetzwerk (RN) mit dem Ausgang des Vergleichers (K) in Verbindung gebracht wird, über das er in einen Ladungszustand versetzt wird, bei dem das Ausgangssignal des Vergleichers einen Zustand einnimmt, der zwischen den beiden Zuständen liegt, die eine positive bzw. eine negative Differenz der an den Vergleichereingängen anliegenden Analogwerte anzeigen, dadurch gekennzeichnet, dass zu Beginn der Abgleichphase das Ausgangssignal des Digital-Analog-Wandlers (D/A) und die am zweiten Vergleichereingang anliegende Signalgrösse, die normalerweise der umzuwandelnde Analogwert ist, zu Null gemacht werden, dass als Rückkopplungsnetzwerk eine Konstantstromquelle (I) verwendet wird, die einen Strom derartiger Polarität liefert, dass eine durch den Eingangsstrom des Vergleichers bewirkte Entladung des Nullabgleichkondensators (CAZK) kompensiert werden kann, und dass diese Konstantstromquelle (I) während der Abgleichphase nur wirksam geschaltet wird, wenn eine Aufladung des Nullabgleichkondensators (CAZK) erforderlich ist, um die genannte Entscheidungsschwelle des Vergleichers (K) zu erreichen und dabei einen Strom derartiger Amplitude liefert, dass sein auf die Abtastperiode, in der jeweils ein zu wandelnder analoger Abtastwert auftritt, bezogener Mittelwert dem über diese Abtastperiode gemittelten Mittelwert des Eingangsstroms des Vergleichers (K) gleich ist.

2. Verfahren nach einem der vorhergehenden Ansprüche, dadurch gekennzeichnet, dass bei Verwendung eines als Operationsverstärker ausgebildeten Strom-Spannungswandlers (V) zur Weitergabe des Ausgangssignals des Digital-Analog-Wandlers (D/A) an den als Spannungsvergleicher arbeitenden Vergleicher (K) im Anschluss an den Nullpunktabgleich des Vergleichers (K) in einer zweiten Abgleichphase das Rückkopplungsnetzwerk (RN) von dem genannten ersten Vergleichereingang abgetrennt und an den nicht mit dem Ausgang des Digital-Analog-Wandlers (D/A) verbundenen Eingang des Strom-Spannungs-Wandlers (V), an dem ebenfalls ein Nullabgleichskondensator (CAZV) angeschlossen ist, gelegt wird, um diesen Kondensator in entsprechender Weise wie den an dem ersten Vergleichereingang liegenden Nullabgleichkondensator (CAZK) in einen für den Nullabgleich geeigneten Ladungszustand zu bringen.

3. Verfahren nach Anspruch 1 oder 2, dadurch gekennzeichnet, dass der an den Ausgang des Digital-Analog-Wandlers (D/A) angeschlossene Eingang des Strom-Spannungs-Wandlers (V) während der zweiten Abgleichphase über einen Widerstand (R2), der klein gegenüber den diesen Eingang mit dem Strom-Spannungs-Wandlerausgang verbindenden Rückkopplungswiderstand (R1) ist, an Bezugspotential gelegt wird.

4. Verfahren nach Anspruch 1, dadurch gekennzeichnet, dass bei Verwendung eines als Operationsverstärker ausgebildeten Spannungs-Strom-Wandlers (V) zur Weitergabe des umzuwandelnden Analogwertes an den als Stromvergleicher arbeitenden Vergleicher (K) im Anschluss an den Nullpunktabgleich des Vergleichers (K) in einer zweiten Abgleichphase das Rückkopplungsnetzwerk (RN) von demjenigen Vergleichereingang, an dem der genannte Nullabgleichkondensator (CAZK) liegt, abgetrennt und an den nicht mit dem Haltekondensator (CS), der den umzuwandelnden Analogwert speichert, verbundenen Eingang des Spannungs-Strom-Wandlers (V) gelegt wird, an den ebenfalls ein Nullabgleichkondensator (CAZV) angeschlossen ist, um diesen Kondensator in entsprechender Weise wie den an dem einen Vergleichereingang liegenden Nullabgleichskondensator (CAZK) in einen für den Nullabgleich geeigneten Ladungszustand zu bringen.

5. Verfahren nach Anspruch 4, dadurch gekennzeichnet, dass der erste über einen Widerstand (R1) an den Ausgang des Spannungs-Strom-Wandlers (V) angeschlossene Eingang des Vergleichers während der zweiten Abgleichphase über einen weiteren Widerstand (R2), der klein gegenüber dem ersten Widerstand (R1) ist, an Bezugspotential gelegt wird.

6. Verfahren nach einem der vorhergehenden Ansprüche, dadurch gekennzeichnet, dass bei einer Schaltungsanordnung, bei der der umzuwandelnde Analogwert über einen Abtastschalter (SE1, SE2) einem Haltekondensator (CS) zugeführt wird und dieser Kondensator durch einen Schalter (S1) überbrückbar ist, und bei der diese Schalter (SE1, SE2, S1) unter Verwendung von MOS-Transistoren realisiert sind, der den Haltekondensator (CS) überbrückende Schalter (S1) unmittelbar vor der Abgleichphase geschlossen, nach einer für die Entladung des Abtastkondensators ausreichenden Zeit jedoch wieder geöffnet wird.

**Claims**

1. A zero offset compensation method for an analogue comparator, in the form of an operational amplifier, of an analogue-digital converter which operates in accordance with the iterative principle using a digital-analogue converter, in particular when this forms part of an A/D and D/A converter (codec), where in the compensating phase a zero offset compensating capacitor (CAZK), which is connected to a first input of the comparator (K), ist connected to the output of the comparator (K) via a feedback network (RN) by which it is brought into a charge state in which the output signal of the comparator assumes a state which lies between the two states which indicate a positive difference and a negative difference respectively between the analogue values present at the comparator inputs, characterised in that at the beginning of the compensating phase the output signal of the digital-analogue converter (D/A) and a signal value which is present at the second comparator input and which is normally the analogue value which is to be converted are rendered zero, that the feedback network comprises a constant current source (I) which supplies a current whose polarity is such that a discharge of the zero offset compensating capacitor (CAZK), effected by the input current of the comparator, can be compensated, and that during the compensating phase this constant current source (I) is actuated only when it is necessary to charge the zero offset compensating capacitor (CAZK) in order to reach the aforesaid decision threshold of the comparator (K), and thereby supplies a current whose amplitude is such that its mean value, relative to the sampling period in which an analogue sample value which is to be converted in each case occurs, is equal to the mean value of the input current of the comparator (K) averaged over this sampling period.

2. A method as claimed in one of the preceding claims, characterised in that when a current-voltage converter (V) in the form of an operational amplifier is used to forward the output signal of the digital-analogue converter (D/A) to the comparator (K) which is operating as voltage comparator, following the zero offset compensation of the comparator (K) in a second compensating phase the feedback network (RN) is cut off from the aforesaid first comparator input and is connected to that input of the current-voltage converter (V) which is not connected to the output of the digital-analogue converter (D/A) and to which a zero offset compensating capacitor (CAZV) is likewise connected, in order that this capacitor, similarly to the zero offset compensating capacitor (CAZK) which is connected to the first comparator input, can be brought into a charge state suitable for the zero offset compensation.

3. A method as claimed in claim 1 or 2, characterised in that during the second compensating phase that input of the current-voltage converter (V) which is connected to the input of the digital-analogue converter (D/A) is connected to reference potential via a resistor (R2) which is small in comparison to the feedback resistor (R1) which connects this input to the current-voltage converter output.

4. A method as claimed in claim 1, characterised in that when a voltage-current converter (V) in the form of an operational amplifier is used to forward the analogue value which is to be converted to the comparator (K) which operates as a current comparator, following the zero offset compensation of the comparator (K) in a second compensating phase, the feedback network (RN) is cut off from the comparator input to which the aforesaid zero offset compensating capacitor (CAZK) is connected and is connected to that input of the voltage-current converter (V) which is not connected to the holding capacitor (CS) which stores the analogue value to be converted and which is likewise connected to a zero offset compensating capacitor (CAZV), in order that this capacitor, similarly to the zero offset compensating capacitor (CAZK) which is connected to the first comparator input, can be brought into a charge state suitable for the zero offset compensation.

5. A method as claimed in claim 4, characterised in that during the second compensating phase, the first input of the comparator, which is connected via a resistor (R1) to the output of the voltage-current converter (V), is connected to reference potential via a further resistor (R2) which is small in value in comparison to the first resistor (R1).

6. A method as claimed in one of the preceding claims, characterised in that in a circuit arrangement in which the analogue value which is to be converted is fed via a sampling switch (SE1, SE2) to a holding capacitor (CS) and this capacitor can be bridged by a switch (S1), and in which these switches (SE1, SE2, S1) are constructed from MOS-transistors, the bridge (S1) which bridges the holding capacitor is closed immediately preceding the compensating phase but is re-opened after a period of time sufficient for the discharging of the sampling capacitor.

## Revendications

1. Procédé pour réaliser le réglage du zéro du comparateur de valeurs analogiques, réalisé sous la forme d'un amplificateur opérationnel, d'un convertisseur analogique/numérique travaillant selon le principe d'itération moyennant l'utilisation d'un convertisseur numérique/analogique, notamment dans le cas de l'appartenance de ce convertisseur analogique/numérique à un dispositif servant à réaliser la conversion analogique/numérique et inversement la conversion numérique/analogique (Codec), et selon lequel pendant la phase de réglage, on raccorde un condensateur de réglage du zéro (CAZK), qui est raccordé à une première entrée du comparateur (K), à la sortie de ce comparateur (K) par l'intermédiaire d'un réseau de réaction (RN), au moyen duquel le condensateur est placé dans un état de charge pour lequel le signal de sortie du comparateur prend un état qui est situé entre les deux états qui indiquent une différence positive ou une différence négative des valeurs analogiques appliquées aux entrées du comparateur, caractérisé par le fait qu'au début de la phase de réglage, on réalise l'annulation du signal de sortie du convertisseur numérique/analogique (D/A) et de la grandeur du signal, qui est appliqué à la seconde entrée du comparateur et est normalement la valeur analogique devant être convertie, qu'on utilise comme réseau de réaction une source de courant constant (I), qui délivre un courant possédant une polarité telle qu'une décharge, provoquée par le courant d'entrée du comparateur, du condensateur de réglage du zéro (CAZK), peut être compensée et que l'on branche cette source de courant constant (I) à l'état actif, pendant la phase de réglage, uniquement lorsqu'une charge du condensateur du réglage du zéro (CAZK) est nécessaire, pour atteindre le seuil de décision indiqué du comparateur (K), et fournit un courant possédant une amplitude telle que sa valeur moyenne, qui est rapportée à la période d'exploration pendant laquelle apparaît respectivement une valeur d'exploration analogique devant être convertie, est égale à la valeur moyenne, formée pendant cette période d'exploration, du courant d'entrée du comparateur (K).

2. Procédé suivant l'une des revendications précédentes, caractérisé en ce que, dans le cas de l'utilisation d'un convertisseur courant-tension (V) réalisé sous la forme d'un amplificateur opérationnel, pour la retransmission du signal de sortie du convertisseur numérique/analogique (D/A) au comparateur (K) travaillant en tant que comparateur de tension à la suite du réglage du zéro du comparateur (K), lors d'une seconde phase de réglage, on déconnecte le réseau de réaction (RN) de la première entrée mentionnée du comparateur et on le raccorde à l'entrée du convertisseur courant-tension (V), qui n'est pas reliée à la sortie du convertisseur numérique/analogique (D/A) et à laquelle est également raccordé un condensateur (CAZV) de réglage du zéro, afin d'amener ce condensateur dans un état de charge convenant pour le réglage du zéro, de la même manière que le condensateur de réglage du zéro (CAZK) raccordé à la première entrée du comparateur.

3. Procédé suivant la revendication 1 ou 2, caractérisé par le fait qu'on raccorde au potentiel de référence l'entrée du convertisseur courant-tension (V), qui est raccordée à la sortie du convertisseur numérique/analogique (D/A), pendant la seconde phase de réglage, par l'intermédiaire d'une résistance (R2) qui est faible par rapport à la résistance de couplage (R1) reliant cette entrée à l'entrée du convertisseur courant-tension.

4. Procédé selon la revendication 1, caractérisé en ce que, dans le cas de l'utilisation d'un convertisseur tension-courant (V) réalisé sous la forme d'un amplificateur opérationnel et servant à retransmettre la valeur analogique devant être convertie, au comparateur (K) travaillant en tant que comparateur de courant, à la suite du réglage du zéro du comparateur (K), lors d'une seconde phase de réglage, on déconnecte le réseau de couplage (RN) de l'entrée du comparateur, à laquelle ledit condensateur du réglage du zéro (CAZK) est raccordé, et on le raccorde à l'entrée du convertisseur tension-courant (V), qui n'est pas reliée au condensateur de maintien (16) qui mémorise la valeur analogique devant être convertie et à laquelle est également raccordée un condensateur de réglage du zéro (CAZV), afin de placer ce condensateur dans un état de charge convenant pour le réglage du zéro, de la même manière que pour le condensateur de réglage du zéro (CAZK) raccordé à l'entrée du comparateur.

5. Procédé suivant la revendication 4, caractérisé par le fait qu'on raccorde le potentiel de référence à la première entrée du comparateur, qui est raccordée par l'intermédiaire d'une résistance (R1) à la sortie du convertisseur tension-courant (V), au potentiel de référence pendant la seconde phase de réglage, par l'intermédiaire d'une autre résistance (R2), qui est faible par rapport à la première résistance (R1).

6. Procédé suivant l'une des revendications précédentes, caractérisé par le fait que dans le cas d'un montage dans lequel la valeur analogique devant être convertie est envoyée par l'intermédiaire d'un interrupteur d'exploration (SE1, SE2) à un condensateur de maintien (16) et dans lequel ce condensateur peut être shunté par l'intermédiaire d'un interrupteur (S1) et dans lequel ces interrupteurs (SE1, SE2, S1) sont réalisés moyennant l'utilisation de transistors MOS, on ferme l'interrupteur (S1), qui shunte le condensateur de maintien (16), juste avant la phase de réglage, mais on l'ouvre à nouveau au bout d'un intervalle de temps suffisant pour la décharge du condensateur d'exploration.

FIG 1

FIG 2

FIG 3

FIG 4

# FIG 5